(19) Europäisches Patentamt
European Patent Office
Office européen des brevets

(11) **EP 3 203 526 B1**

(12) **FASCICULE DE BREVET EUROPEEN**

(45) Date de publication et mention de la délivrance du brevet:
**25.05.2022 Bulletin 2022/21**

(21) Numéro de dépôt: **17154326.7**

(22) Date de dépôt: **02.02.2017**

(51) Classification Internationale des Brevets (IPC):
**H01L 29/778** *(2006.01)*    **H01L 29/10** *(2006.01)*
**H01L 29/20** *(2006.01)*    **H01L 29/207** *(2006.01)*

(52) Classification Coopérative des Brevets (CPC):
**H01L 29/207; H01L 29/1075; H01L 29/2003; H01L 29/7786**

(54) **TRANSISTOR À HÉTÉROJONCTION À CONFINEMENT DE GAZ D'ÉLECTRONS AMÉLIORÉ**

TRANSISTOR MIT HETEROÜBERGANG MIT VERBESSERTEM ELEKTRONENGAS-EINSCHLUSS

HETEROJUNCTION TRANSISTOR WITH IMPROVED ELECTRON GAS CONFINEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.02.2016 FR 1650899**

(43) Date de publication de la demande:
**09.08.2017 Bulletin 2017/32**

(73) Titulaire: **Commissariat à l'énergie atomique et aux énergies alternatives
75015 Paris (FR)**

(72) Inventeur: **MORVAN, Erwan
38160 Montagne (FR)**

(74) Mandataire: **INNOV-GROUP
310, avenue Berthelot
69372 Lyon Cedex 08 (FR)**

(56) Documents cités:
**US-A1- 2011 272 708**

• **WANG MAOJUN ET AL: "Normally-off hybrid Al2O3/GaN MOSFET on silicon substrate based on wet-etching", 2013 25TH INTERNATIONAL SYMPOSIUM ON POWER SEMICONDUCTOR DEVICES & IC'S (ISPSD), IEEE, 15 juin 2014 (2014-06-15), pages 253-256, XP032620486, ISSN: 1943-653X, DOI: 10.1109/ISPSD.2014.6856024 ISBN: 978-1-4673-5134-8 [extrait le 2014-07-14]**

**Description**

L'invention concerne les transistors à haute mobilité électronique basés sur la présence d'hétérojonctions, et en particulier les transistors à hétérojonction faisant appel à des couches semi-conductrices de GaN.

De nombreuses applications électroniques nécessitent dorénavant une amélioration de performances surtout dans l'électronique embarquée à destination de l'automobile et des transports terrestres, dans l'aéronautique, dans les systèmes médicaux ou dans des solutions domotiques par exemple. Ces applications nécessitent pour la plupart des commutateurs pour forte puissance fonctionnant dans des gammes de fréquences fréquemment supérieures au megahertz.

Historiquement, des commutateurs de puissance ont longtemps fait appel à des transistors à effet de champ basés sur un canal semi-conducteur, le plus souvent du silicium. Pour des fréquences plus faibles, les transistors à jonction sont préférés car ils supportent des densités de courant plus élevées. Cependant, du fait de la tension de claquage relativement limitée de chacun de ces transistors, les applications de puissance nécessitent l'utilisation d'un grand nombre de transistors en série, ou des transistors plus longs, ce qui aboutit à une résistance de passage plus élevée. Les pertes à travers ces transistors en série sont considérables, aussi bien en régime établi qu'en commutation.

Une alternative pour des commutateurs de puissance, notamment à hautes fréquences, est l'utilisation de transistors à effet de champ à haute mobilité d'électrons, également désignés par le terme de transistor à effet de champ à hétérostructure. Un tel transistor inclut la superposition de deux couches semi-conductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Parmi les transistors HEMT à large bande d'énergie interdite, les transistors à base de nitrure de gallium sont très prometteurs. Leur largeur de bande d'énergie interdite induit un champ électrique critique plus élevé comparé aux matériaux classiques de l'électronique, une vitesse de saturation élevée des porteurs et de bonnes stabilités thermique et chimique. Le champ de claquage du nitrure de gallium peut ainsi être supérieur à $2 \times 10^6$ V/cm, ce qui permet aisément de réaliser des transistors compacts avec des tensions de claquage supérieures à 600 V. De plus, de tels transistors permettent de très grandes densités de courant du fait de la très grande mobilité électronique et de la forte densité électronique dans le gaz d'électrons d'interface.

Le document 'Characteristics of AlGaN/GaN/AlGaN double heterojunction HEMTs with an improved breakdown voltage' publié dans l'édition de janvier 2012, volume 33, numéro 1 de Journal of Semiconductors, décrit une première structure de transistor HEMT. Cette structure comprend un substrat en SiC, surmonté d'une couche de nucléation en AlN de 100 nm, surmontée d'une couche tampon en GaN de 1,5 $\mu$m, surmontée d'une couche intermédiaire en AlN de 1 nm, surmontée d'une couche barrière en AlGaN de 22 nm, surmontée d'une couche de GaN de 1 nm, sur laquelle la source, la grille et le drain du transistor sont formés. Une couche de gaz d'électrons est formée à l'interface entre la couche tampon de GaN et la couche barrière d'AlGaN, la couche intermédiaire en AlN étant considéré comme appartenant à cette interface.

En pratique, la couche tampon en GaN présente une barrière de potentiel relativement basse, de sorte que des électrons de la couche de gaz d'électrons peuvent facilement sortir du puits de potentiel pour être piégés dans la couche tampon en GaN, par exemple dans le cas où le transistor est bloqué. Les performances de conduction du transistor sont alors fortement dégradées car la densité en électrons est réduite.

Il a été proposé d'inclure du carbone ou du magnésium dans la couche tampon à une proportion non négligeable afin de limiter la sortie du puits de potentiel en élevant la bande de conduction. Cependant, les électrons sortants effectivement du puits de potentiel sont alors piégés dans la couche tampon où une forte concentration de niveau profonds est présente.

Le document 'Characteristics of AlGaN/GaN/AlGaN double heterojunction HEMTs with an improved breakdown voltage' décrit une deuxième structure de transistor HEMT destinée à former une barrière électrique entre la couche de gaz d'électrons et la couche tampon, afin d'empêcher l'injection des électrons vers cette couche tampon. Cette structure comprend un substrat en SiC, surmonté d'une couche de nucléation en AlN de 100 nm, surmontée d'une couche tampon en $Al_{0,07}Ga_{0,93}N$ de 1,5 $\mu$m, surmontée d'une couche de canal en GaN de 10 nm, surmontée d'une couche intermédiaire en AlN de 1 nm, surmontée d'une couche barrière en AlGaN de 22 nm, surmontée d'une couche de GaN de 1 nm, sur laquelle la source, la grille et le drain du transistor sont formés. Une couche de gaz d'électrons est formée à l'interface entre la couche de canal en GaN et la couche barrière d'AlGaN, la couche intermédiaire en AlN étant considéré comme appartenant à cette interface. Cette structure est désignée par le terme de HEMT à double heterojonction. La couche tampon permet de relever l'énergie de la bande de conduction et confine les électrons dans la couche canal.

Cependant, une telle structure présente encore une barrière électrique insuffisante. En outre, la présence de la couche barrière en AlGaN induit des contraintes mécaniques supplémentaires dans la structure du transistor.

Le document US2011/272708 décrit un transistor à hétérojonction à haute mobilité électronique de type normalement ouvert, comprenant notamment :

- une première couche de GaN;
- une deuxième couche de GaN à dopage de type P formée sur la première couche de GaN;
- une troisième couche de GaN à dopage de type N formée sur la deuxième couche de GaN de façon à former une jonction p/n déplétée.

Le document 'Normally-Off $Al_2O_3$/GaN MOSFET on Silicon Substrate based on Wet-Etching', publié par Mrs Wang et alias dans le cadre 26ème Symposium International Power Semiconductor Devices & IC's qui s'est tenu du 15 au 19 Juin 2014 à Hawaï, décrit un transistor MOSFET fabriqué sur un substrat de Silicium. Le fonctionnement en normalement ouvert est obtenu par un renfoncement de grille utilisant une oxydation et une gravure humide pour le retrait d'une barrière AlGaN.

L'invention vise à résoudre un ou plusieurs de ces inconvénients. L'invention porte ainsi sur un transistor à hétérojonction à haute mobilité électronique, tel que défini dans la revendication 1.

L'invention porte également sur les variantes des revendications annexées. L'homme du métier comprendra que chacune des caractéristiques des variantes des revendications dépendantes peut être combinée indépendamment aux caractéristiques ci-dessus, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :

- la figure 1 est une vue en coupe d'un exemple de transistor à hétérojonction à haute mobilité électronique selon l'invention ;
- les figures 2 et 3 sont des diagrammes de bandes de conduction d'un transistor selon l'invention et d'un transistor selon l'état de la technique ;
- la figure 4 est une vue en coupe d'un exemple d'une autre variante de transistor à heterojonction à haute mobilité électronique selon l'invention.

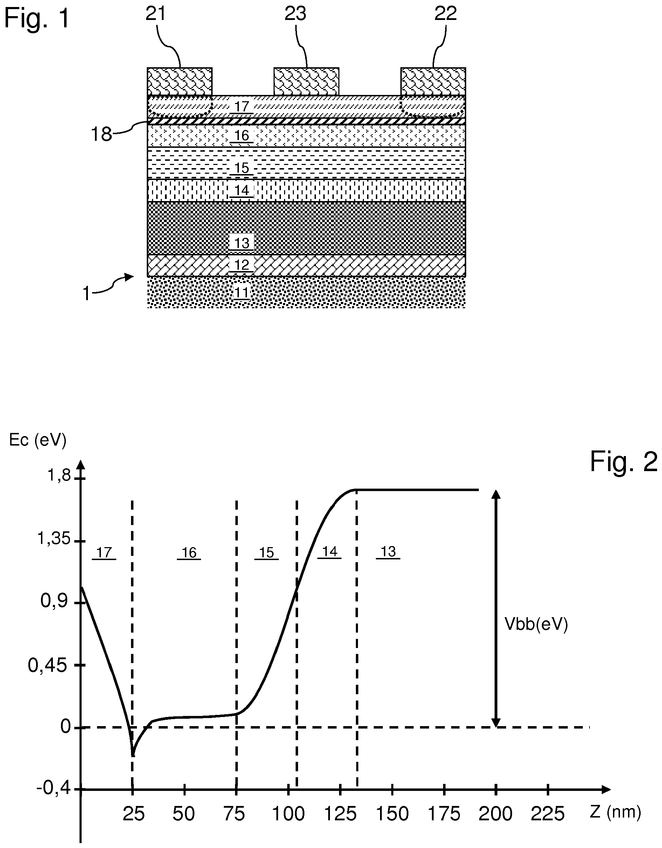

La figure 1 est une vue en coupe schématique d'un exemple de transistor à hétérojonction à haute mobilité électronique selon un mode de réalisation de l'invention. Le transistor 1 comporte un substrat 11, une couche intermédiaire 12 disposée sur le substrat 11, une couche tampon de GaN 13 disposée sur la couche intermédiaire 12, une couche de GaN dopée P 14 disposée sur la couche tampon de GaN 13, une couche de GaN dopée N 15 disposée sur la couche de GaN 14, et une couche de GaN non intentionnellement dopée 16 disposée sur la couche 15. Le transistor 1 comprend en outre une couche d'AlGaN 17 disposée sur la couche 16. Un gaz d'électrons est intrinsèquement formé par hétérojonction à l'interface entre la couche 17 et la couche 16. Dans un souci de lisibilité, le gaz d'électrons est illustré sous forme de couche 18 à l'interface entre la couche 16 et la couche 17. Une couche intermédiaire non illustrée peut être interposée entre les couches 16 et 17, par exemple pour accroître la densité d'électrons et la mobilité dans le gaz d'électrons. Une telle couche intermédiaire est typiquement extrêmement fine (par exemple 1nm) est peut être réalisée en AlN (particulièrement adapté à l'interface entre une couche 16 en GaN et une couche 17 en AlGaN).

De façon connue en soi, le transistor 1 comporte une source 21, un drain 22 et une grille de commande 23 formés sur la couche d'AlGaN 17. La source 21, le drain 22 et la grille de commande 23 sont illustrés uniquement schématiquement, leurs dimensions et leurs structures pouvant différer fortement de l'illustration de la figure 1.

Le substrat 11 peut être un isolant ou un semi-conducteur de type silicium intrinsèque ou dopé, ou du SiC ou du saphire. Le substrat 11 peut typiquement présenter une épaisseur de l'ordre de 650 $\mu$m à 1mm.

La couche intermédiaire 12 (pouvant être formée d'une superposition de couches de transition) est déposée sur le substrat 11. La couche de transition 12 permet d'adapter les paramètres de maille cristalline entre les couches 11 et 13 de GaN. Cela permet de gérer les contraintes mécaniques entre le substrat 11 et une partie active de couches formées par l'épitaxie. La couche 12 peut inclure la superposition d'une couche de nucléation (typiquement de l'AlN avec une épaisseur d'environ 100nm) et plusieurs couches d'adaptation (par exemple plusieurs couches d'AlGaN avec une fraction molaire d'AlN décroissante, ou bien un super-réseau comprenant plusieurs bicouches AlxGa(1-x)N/GaN).

Une telle couche intermédiaire 12 s'avère particulièrement avantageuse en cas de forte inadaptation de paramètres de maille entre la couche 13 et le substrat 11, qui pourrait aboutir à des dislocations mécaniques dans ces couches.

La couche tampon 13 peut présenter une épaisseur dépendante de la tension visée pour le transistor 1, par exemple une épaisseur de quelques microns. Une épaisseur relativement importante de la couche tampon 13 permet de limiter les courants de fuite latéraux et verticaux dans le transistor 1 et aussi de mieux confiner la couche de gaz d'électrons 18. La couche tampon 13 peut par exemple être réalisée en GaN-Si (semi-isolant) dopé Carbone ou en la superposition d'une couche de GaN-Si/ AlxGa(1-x)N avec x faible, par exemple compris entre 4 à 8%.

La couche de GaN dopée P 14 présente par exemple une épaisseur de 50 nm et une concentration en accepteurs $N_A$ de $1 * 10^{17}$ cm$^{-3}$. La couche de GaN dopée N 15 présente par exemple une épaisseur de 80 nm et une concentration en donneurs $N_D$ de $2 * 10^{16}$ cm$^{-3}$. Les couches 14 et 15 présentent une concentration en carbone inférieure à celle de la couche 13. Cette concentration en carbone est par exemple inférieure à $1*10^{16}$ cm$^{-3}$.

La couche de GaN non intentionnellement dopée 16 présente par exemple une épaisseur de 50 nm. Afin de favoriser une mobilité d'électrons maximale dans la couche de gaz d'électrons 18, la couche de GaN 16 présente un dopage le plus réduit possible. On considèrera par exemple qu'une couche 16 est non intentionnellement dopée si la concentration en dopants N et P est inférieure à $1 * 10^{16}$ cm$^{-3}$. La couche d'AlGaN 17 présente par exemple une épaisseur de 25 nm.

Le dopage de la couche 14 dopée P est réalisé avec du Magnésium, élément chimique qui peut aisément être intégré dans la couche 14 lors d'une éventuelle formation par épitaxie. En outre, le Magnésium peut aisément être activé. Avantageusement, le dopage de la couche 15 dopée N est réalisé avec du Silicium, élément chimique qui peut aisément être intégré dans la couche 15 lors d'une éventuelle formation par épitaxie.

La superposition de la couche de GaN dopée P 14 à la couche de GaN dopée N 15 permet de former une jonction P/N déplétée, de façon à former une barrière de potentiel particulièrement élevée sous la couche de gaz d'électrons. La jonction P/N formée est complètement déplétée avec des épaisseurs et concentrations en dopants appropriées dans les couches 14 et 15. En outre, une telle jonction est formée avec des matériaux compatibles avec la couche de GaN 16 non intentionnellement dopée destinée à former la couche de gaz d'électrons. En outre, une telle barrière de potentiel permet d'éviter la formation d'une couche d'AlGaN sous cette couche de GaN non intentionnellement dopée 16, ce qui permet de limiter les contraintes mécaniques à l'interface avec cette couche de GaN 16.

Cette solution technique de l'invention peut s'appliquer à la fois pour un transistor de type normalement ouvert, non revendiqué, ou un transistor de type normalement fermé selon l'invention.

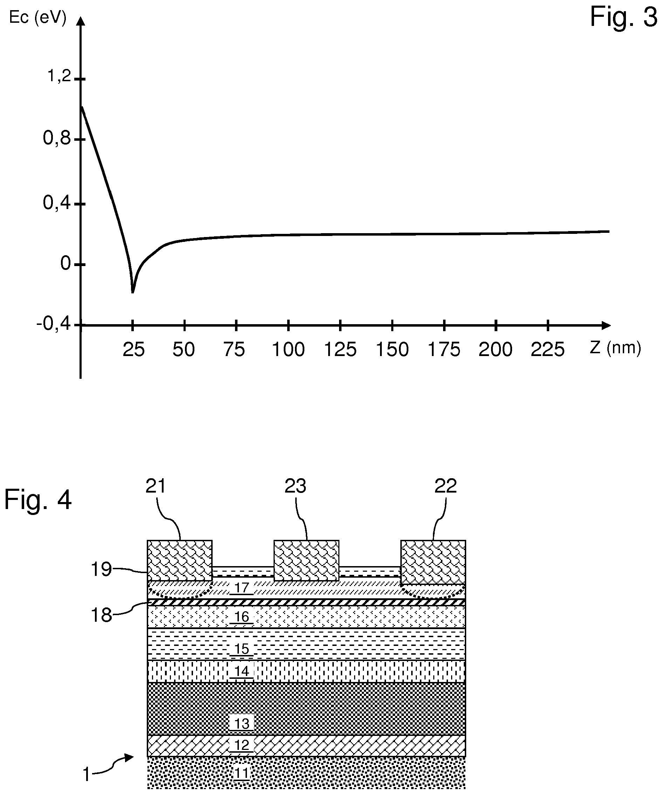

La figure 2 est un diagramme de bande de conduction du transistor 1 détaillé auparavant en fonction de la profondeur. À titre de comparaison, la figure 3 fournit un diagramme de bande de conduction d'un transistor de l'état de la technique en fonction de la profondeur. Le transistor de l'état de la technique pris en compte comporte une couche d'AlGaN de 25 nm formée sur une couche de GaN non intentionnellement dopée d'une épaisseur de 1,40 μm.

On constate que la barrière de potentiel pour le transistor 1 selon l'invention est d'environ 1,3 eV. A contrario, la barrière de potentiel du transistor selon l'état de la technique est d'environ 0,15 eV. Le transistor 1 selon l'invention permet ainsi d'obtenir une barrière de potentiel particulièrement élevée pour éviter le piégeage des électrons de la couche de gaz d'électrons 18 dans la couche 13 par exemple. Des simulations ont permis de déterminer que la densité d'électrons dans les couches de gaz d'électrons respectives de ces transistors sont sensiblement équivalentes, d'environ $8,5 * 10^{12}$ cm$^{-2}$ pour le transistor de l'exemple de la figure 3 contre environ $8,2 * 10^{12}$ cm$^{-2}$ pour le transistor de l'exemple de la figure 2. La densité d'électrons de la couche de gaz d'électrons 18 selon l'invention reste donc particulièrement élevée.

L'influence de différents paramètres des couches 14, 15 et 16 sur la formation d'une barrière de potentiel pour la couche de gaz d'électrons 18 et la couche de GaN 16 sera davantage détaillée par la suite.

Selon une variante illustrée à la figure 4, une couche 19 de GaN est formée de façon connue en soi sur la couche d'AlGaN 17, afin d'éviter une oxydation de la couche d'AlGaN 17. On grave la couche 19 sous les contacts pour créer un contact avec la couche 17. La couche 19 présente par exemple une épaisseur comprise entre 1 et 3nm.

Pour permettre d'anticiper l'influence de différents paramètres sur les performances du transistor 1 selon l'invention, les notations suivantes vont être utilisées par la suite :

$Ns$ : la densité d'électrons dans la couche de gaz d'électrons (en cm$^{-2}$);
$\mu_{2DEG}$ : la mobilité des électrons dans la couche de gaz d'électrons (en cm$^2$/Vs) ;
$N_D$ : la densité volumique de donneurs dans la couche de GaN 15 dopée N (en cm$^{-3}$) ;
$N_A$: la densité volumique d'accepteurs dans la couche de GaN 14 dopée P (en cm$^{-3}$) ;
$N_{A-}$ : la densité volumique d'accepteurs dans une couche de GaN dopée P suffisamment épaisse pour être non déplétée (en cm$^{-3}$) ;
$N_{D+}$ : la densité volumique de donneurs dans une couche de GaN dopée N suffisamment épaisse pour être non déplétée (en cm$^{-3}$) ;
$ni$ : la densité de porteurs intrinsèques dans une couche de GaN à température ambiante (en cm$^{-3}$) ;
$RT$ : (pour Room Temperature en langue anglaise) la température ambiante prise en compte de 300K ;
$T$ : la température du substrat en K ;
$Nsc$ : la densité d'électrons dans la couche 16 du transistor 1 (en cm$^{-2}$);
$Wn$ : l'épaisseur de la couche de GaN 15 dopée N;
$Wnid$ : l'épaisseur de la couche de GaN 16 non intentionnellement dopée;
$Wp$ : l'épaisseur de la couche de GaN 14 dopée P;
$Vbi$ : le potentiel de diffusion (désigné par le terme de 'built-in potential' en langue anglaise) de la jonction P/N formée à l'interface entre les couches 14 et 15 ;
$Vbbpn$ : la barrière de potentiel aux bornes de la jonction P/N déplétée ;
$Vbbnid$ : la barrière de potentiel aux bornes de la couche de GaN 16 non intentionnellement dopée ;
$Vbb$ : la barrière de potentiel totale ;

$\varepsilon_0$: la permittivité du vide ;
$\varepsilon_{sc}$: la permittivité du GaN ;
k : la constante de Boltzman = 1,3806488 $E^{-23}$ J/K
q : la charge électronique $\approx$ 1,6 $E^{-19}$ C.

Les accès du transistor 1 incluent les zones entre grille de commande 23 et drain 22, et entre grille de commande 23 et source 21, en incluant la couche de gaz d'électrons 18.

Le potentiel de diffusion de la jonction entre les couches 14 et 15 peut se définir comme suit :

$$V_{bi(T)} = \frac{k \cdot T}{q} ln\left(\frac{N_{A(T)}^- . N_{D(T)}^+}{n_{i(T)}^2}\right)$$

Avec un dopage P réalisé avec du Magnésium, l'énergie d'ionisation de l'accepteur Mg dans le GaN est d'environ 180meV. L'ionisation est donc partielle à la température RT. Il faut donc en tenir compte pour le calcul du Vbi par l'inégalité $N_{A-} < N_A$ à la température RT.

Avec ni = 1.9 $e^{-10}$ $cm^{-3}$ à la température RT, $N_D \approx N_{D+}$ =1 $e^{16}cm^{-3}$ (avec un dopage Silicium) et $N_{A-}$ = 1e$^{17}cm^{-3}$, on obtient Vbi $\approx$ 3.1 V. Vbi reste peu sensible aux variations de $N_{A-}$ et $N_{D+}$ en raison du logarithme dans la relation et de la faible valeur de ni.

La barrière de potentiel formée entre la couche de gaz d'électrons 18 et la couche tampon 13 (empêchant l'injection et le piégeage des électrons dans les couches profondes de la couche tampon 13) apparaît grâce au potentiel de diffusion Vbi, et inclut :

- en partie une barrière de potentiel aux bornes de la jonction P/N formée entre les couches 14 et 15 :

$$V_{bbpn} = \frac{q}{2\varepsilon_s}\left(N_A . W_p^2 + 2N_A \cdot W_p \cdot W_n - N_D . W_n^2\right)$$

- en partie une barrière de potentiel aux bornes de la couche GaN 16 :

$$V_{bbnid} = \frac{q}{\varepsilon_s}\left(N_A . W_p - N_D \cdot W_n\right). W_{nid}$$

Dans la zone de charge d'espace de la jonction p/n, tous les accepteurs et donneurs sont ionisés et c'est donc leur concentration totale qui intervient dans les calculs (Na- =Na et Nd+ =Nd).

La barrière de potentiel obtenue par la combinaison des couches 14 et 15 atteint un niveau plus élevé que celui d'une éventuelle couche d'AlGaN placée sous la couche 16 de formation du gaz d'électrons (comme l'exemple détaillé dans 'Characteristics of AlGaN/GaN/AlGaN double heterojunction HEMTs with an improved breakdown voltage' cité en introduction).

On peut citer des règles de conception d'un tel transistor 1.

Lorsque le dopant de la couche 14 est du Magnésium les limites extrêmes pour $N_A$ sont fixée par :

- les capacités de la technologie d'épitaxie à incorporer et activer le Magnésium dans la couche 14 de GaN (en prenant en compte une limite de solubilité et la passivation par des complexes de type Mg-H notamment). La valeur maximale utilisable pour $N_A$ est à ce jour a priori de 1e$^{19}cm^{-3}$
- La valeur nécessaire pour avoir un Vbi>3V, soit $N_A$ >3e$^{16}cm^{-3}$

On peut théoriquement concevoir un transistor 1 selon l'invention dans cette plage de valeurs. En pratique, on utilisera avantageusement une concentration 1e$^{17}cm^{-3}$ < NA < 1e$^{18}cm^{-3}$. NA>1e$^{17}cm^{-3}$ permet d'obtenir une barrière de potentiel enterrée (Back Barrier en langue anglaise) significative (>1.3V) et $N_A$ < 1e$^{18}cm^{-3}$ permet d'obtenir une épaisseur robuste pour la couche p 14 (Wp>15nm).

Pour la couche 15, on peut sélectionner par exemple une valeur $N_D$ comprise entre 1e$^{17}cm^{-3}$ et $N_A$, en particulier avec du Si comme dopant.

On peut ensuite calculer le potentiel de diffusion Vbi selon la relation détaillée précédemment.

On peut alors calculer une épaisseur correspondante Wn0 de déplétion totale dans une couche GaN n et une épaisseur correspondante Wp0 de déplétion totale dans une couche GaN P dans le cas où les couches N et P auraient des épaisseurs supérieures à Wn0 et Wp0, respectivement.

On peut ensuite déterminer les épaisseurs des couches GaN 15 et GaN 14 à réaliser pour que celles-ci soient complètement déplétées, en respectant seulement les inégalités suivantes :

$$Wn0 \geq Wn$$

; et

$$Wp0 \geq Wp$$

La couche de GaN 14 est avantageusement complètement déplétée, pour éviter de conserver une couche conductrice de trous qui empêcherait le champ électrique de se développer dans l'épaisseur de la couche de GaN 13, ce qui induirait une forte dégradation de la tenue en tension du transistor.

$$W_p < W_{p0} = \sqrt{\frac{2\varepsilon_s \, V_{bi} \, N_D}{q \, . N_A \, (N_A + N_D)}}$$

Avec Vbi = 3,1V, $N_A = 1 * 10^{18}$ cm$^{-3}$ et $N_D = 1 * 10^{18}$ cm$^{-3}$, on obtient une valeur de $W_{p0}$ de 41 nm. On utilise avantageusement une valeur $W_p$ suffisamment élevée pour pouvoir être réalisée par épitaxie avec robustesse (par exemple $W_p > 10$nm). On peut choisir une valeur $W_p$ de 28nm par exemple. Une diminution de la valeur $W_p$ abaisse le niveau de la barrière de potentiel. Par contre, une diminution de la valeur $W_p$ garantit la déplétion de la couche de GaN 14. Avantageusement, $W_p$ est compris entre 30 et 50nm, et de préférence égal à 50nm.

Pour obtenir une déplétion complète de la couche GaN 15, on vérifie la relation suivante :

$$W_n < W_{n0} = \sqrt{\frac{2\varepsilon_s \, V_{bi} \, N_A}{q \, . N_D \, (N_A + N_D)}}$$

Avec $N_A = N_D = 1e18$cm$^{-3}$, $W_{no} = 41$ nm, on peut choisir une valeur $W_n$ de 28nm par exemple.

Avantageusement, $Wn \geq 0,2 * Wn0$ ou $Wn \geq 10$nm, afin d'éviter que la déplétion n'ait un impact sur la couche de gaz d'électrons 18. En effet, la couche 15 doit absorber une proportion non négligeable du potentiel de diffusion. Une épaisseur Wn suffisamment élevée est en outre utilisée pour que la barrière de potentiel générée par la jonction soit suffisante pour empêcher l'injection d'électrons avec une charge d'espace suffisante développée dans la couche 15. Une valeur Wn de 28 nm est par exemple satisfaisante.

Avantageusement, Wn0 est supérieur à Wn (par exemple Wn0 > Wn), de sorte que la couche de GaN 15 soit complètement déplétée sous les électrodes du transistor 1. Par exemple, pour une valeur Wn0 de 41 nm, on peut choisir une valeur Wn inférieure à 41nm.

Avec Wn =28nm et Wp = 28nm et $N_A = N_D = 1e^{18}$cm$^{-3}$, on obtient une barrière de potentiel d'environ 1,7eV dont 0,9eV aux bornes de la jonction et 0,3eV aux bornes de la couche 16.

L'épaisseur de la couche 16 est avantageusement suffisamment épaisse pour éviter toute perturbation de la couche de gaz d'électrons 18 au niveau des électrodes du transistor par l'influence des dopants des couches 14 et 15. Ainsi, avantageusement, $100$ nm $\geq$ Wnid $\geq 50$nm (par exemple obtenu avec Wn=28nm et Wn+Wnid $\geq 78$nm pour limiter l'influence du magnésium sur la couche de gaz d'électrons 18). Avantageusement, Wnid = 50nm.

Les couches 12 à 18 peuvent être formées successivement dans une même machine d'épitaxie en phase vapeur, en changeant bien entendu les conditions d'épitaxie pour chacune des couches. Les paramètres d'épitaxie pour la formation de chacune des couches sont connus en soi de l'homme du métier.

Dans l'exemple illustré, la couche barrière 17 est formée en AlGaN. Selon l'invention, toute autre couche semiconductrice peut être disposée sur la couche 16 de GaN non intentionnellement dopée, si elle est adaptée pour générer un gaz d'électrons à leur interface. La couche 17 peut par exemple être un autre alliage ternaire de nitrure d'élément III. La couche 17 peut aussi être un alliage binaire de nitrure d'élément III, par exemple du AlN.

Dans l'exemple l'AlGaN de la couche 17 peut comprendre une concentration en Aluminium comprise entre 6 et 9% mais d'autres proportions d'Aluminium peuvent bien entendu être utilisées.

Dans les différentes variantes, on peut envisager d'interposer une couche d'AlN entre une couche d'AlGaN 17 et une couche de GaN 16, afin d'augmenter le confinement du gaz d'électrons et sa mobilité. Cette couche d'AlN présente avantageusement une épaisseur comprise entre 5Angstrom et 2nm.

La couche 17 peut avantageusement être recouverte d'une couche de passivation, afin notamment d'améliorer l'isolation entre les électrodes du transistor 1. La couche de passivation peut par exemple être réalisée en SiN. Une couche de SiN peut être déposée par épitaxie, sans retirer le wafer de l'installation d'épitaxie après la formation des couches 16 et 17.

**Revendications**

1. Transistor (1) à hétérojonction à haute mobilité électronique de type normalement fermé, comprenant

   - une première couche de GaN (13);
   - une deuxième couche de GaN (14) à dopage de type P formée sur la première couche de GaN, cette deuxième couche de GaN (14) incluant du Magnésium formant un dopant de type P, la concentration en magnésium dans la deuxième couche de GaN (14) étant au moins égale à $5 * 10^{16}$ $cm^{-3}$ et au maximum égale à $2 * 10^{18}$ $cm^{-3}$, ladite deuxième couche de GaN (14) présentant une épaisseur comprise entre 20 et 50 nm ;
   - une troisième couche de GaN (15) à dopage de type N formée sur la deuxième couche de GaN de façon à former une jonction p/n complètement déplétée ;
   - une quatrième couche de GaN (16) non intentionnellement dopée et formée sur la troisième couche de GaN;
   - une couche semi conductrice (17) formée à l'aplomb de la quatrième couche de GaN non intentionnellement dopée pour former une couche de gaz d'électrons (18) à l'interface entre la couche semi conductrice (17) et la quatrième couche de GaN (16) ;
   - une grille de commande formée sur la couche semi-conductrice (17).

2. Transistor à hétérojonction selon la revendication 1, dans lequel la troisième couche de GaN (15) inclut du Silicium formant un dopant de type N.

3. Transistor à hétérojonction selon la revendication 2, dans lequel la concentration en Silicium dans la troisième couche de GaN (15) est au moins égale à $1,5 * 10^{16}$ $cm^{-3}$.

4. Transistor à hétérojonction selon la revendication 2 ou 3, dans lequel la concentration en Silicium dans la troisième couche de GaN (15) est au maximum égale à $2 * 10^{18}$ $cm^{-3}$.

5. Transistor à hétérojonction selon l'une quelconque des revendications précédentes, dans lequel ladite troisième couche de GaN (15) présente une épaisseur comprise entre 10 et 100 nm.

6. Transistor à hétérojonction selon l'une quelconque des revendications précédentes, dans lequel ladite quatrième couche (16) comporte une concentration en dopants inférieure à $1 * 10^{16}$ $cm^{-3}$.

7. Transistor à hétérojonction selon l'une quelconque des revendications précédentes, dans lequel ladite quatrième couche (16) présente une épaisseur comprise entre 50 et 100nm.

8. Transistor à hétérojonction selon l'une quelconque des revendications précédentes, dans lequel ladite première couche de GaN (13) présente une concentration en carbone supérieure à celle des deuxième et troisième couches de GaN.

9. Transistor à hétérojonction (1) selon l'une quelconque des revendications précédentes, dans lequel ladite couche semi conductrice (17) inclut de l'AlGaN.

10. Transistor à hétérojonction (1) selon l'une quelconque des revendications précédentes, comprenant une autre couche semiconductrice en AlN d'une épaisseur comprise entre 0,5 et 2nm disposée entre la quatrième couche de GaN et ladite couche semiconductrice formée à l'aplomb de la quatrième couche de GaN.

**Patentansprüche**

1. Transistor (1) mit Heteroübergang mit hoher Elektronenbeweglichkeit vom normalerweise geschlossenen Typ, umfassend

- eine erste GaN-Schicht (13);
- eine zweite p-dotierte GaN-Schicht (14), die auf der ersten GaN-Schicht gebildet ist, wobei diese zweite GaN-Schicht (14) Magnesium beinhaltet, das ein p-Dotierungsmittel bildet, wobei die Magnesiumkonzentration in der zweiten GaN-Schicht (14) mindestens $5 * 10^{16}$ cm$^{-3}$ und höchstens $2 * 10^{18}$ cm$^{-3}$ beträgt, wobei die zweite GaN-Schicht (14) eine Dicke zwischen 20 und 50 nm aufweist;
- eine dritte n-dotierte GaN-Schicht (15), die auf der zweiten GaN-Schicht gebildet ist, so dass ein voll depletierter p/n-Übergang gebildet wird;
- eine vierte GaN-Schicht (16), die nicht absichtlich dotiert ist und auf der dritten GaN-Schicht gebildet ist;
- eine halbleitende Schicht (17), die in der Lotrechten zu der nicht absichtlich dotierten vierten GaN-Schicht gebildet ist, um eine Elektronengasschicht (18) an der Grenzfläche zwischen der halbleitenden Schicht (17) und der vierten GaN-Schicht (16) zu bilden;
- ein Steuer-Gate, das auf der halbleitenden Schicht (17) gebildet ist.

2. Transistor mit Heteroübergang nach Anspruch 1, bei dem die dritte GaN-Schicht (15) Silicium beinhaltet, das ein n-Dotierungsmittel bildet.

3. Transistor mit Heteroübergang nach Anspruch 2, bei dem die Siliciumkonzentration in der dritten GaN-Schicht (15) mindestens $1,5 * 10^{16}$ cm$^{-3}$ beträgt.

4. Transistor mit Heteroübergang nach Anspruch 2 oder 3, bei dem die Siliciumkonzentration in der dritten GaN-Schicht (15) höchstens $2 * 10^{18}$ cm$^{-3}$ beträgt.

5. Transistor mit Heteroübergang nach einem der vorhergehenden Ansprüche, bei dem die dritte GaN-Schicht (15) eine Dicke zwischen 10 und 100 nm aufweist.

6. Transistor mit Heteroübergang nach einem der vorhergehenden Ansprüche, bei dem die vierte Schicht (16) eine Dotierungsmittelkonzentration von weniger als $1 * 10^{16}$ cm$^{-3}$ aufweist.

7. Transistor mit Heteroübergang nach einem der vorhergehenden Ansprüche, bei dem die vierte Schicht (16) eine Dicke zwischen 50 und 100 nm aufweist.

8. Transistor mit Heteroübergang nach einem der vorhergehenden Ansprüche, bei dem die erste GaN-Schicht (13) eine Kohlenstoffkonzentration aufweist, die höher als die der zweiten und dritten GaN-Schichten ist.

9. Transistor mit Heteroübergang (1) nach einem der vorhergehenden Ansprüche, bei dem die halbleitende Schicht (17) AlGaN beinhaltet.

10. Transistor mit Heteroübergang (1) nach einem der vorhergehenden Ansprüche, der eine weitere halbleitende Schicht aus AlN mit einer Dicke zwischen 0,5 und 2 nm umfasst, die zwischen der vierten GaN-Schicht und der in der Lotrechten zur vierten GaN-Schicht gebildeten halbleitenden Schicht angeordnet ist.


**Claims**

1. Normally closed high electron mobility heterojunction transistor (1), comprising:

- a first GaN layer (13);
- a second, p-doped GaN layer (14) formed on top of the first GaN layer, this second GaN layer (14) including magnesium forming a p-type dopant, the concentration of magnesium in the second GaN layer (14) being at least equal to $5 * 10^{16}$ cm$^{-3}$ and at most equal to $2 * 10^{18}$ cm$^{-3}$, the thickness of said second GaN layer (14) being between 20 and 50 nm;
- a third, n-doped GaN layer (15) formed on top of the second GaN layer so as to form a fully depleted p-n junction;
- a fourth GaN layer (16), which is not intentionally doped, formed on top of the third GaN layer;
- a semiconductor layer (17) formed plumb with the fourth GaN layer, which is not intentionally doped, in order to form an electron gas layer (18) at the interface between the semiconductor layer (17) and the fourth GaN layer (16);

- a control gate formed on the semiconductor layer (17).

2.  Heterojunction transistor according to Claim 1, in which the third GaN layer (15) includes silicon forming an n-type dopant.

3.  Heterojunction transistor according to Claim 2, in which the concentration of silicon in the third GaN layer (15) is at least equal to $1.5 * 10^{16}$ cm$^{-3}$.

4.  Heterojunction transistor according to Claim 2 or 3, in which the concentration of silicon in the third GaN layer (15) is at most equal to $2 * 10^{18}$ cm$^{-3}$.

5.  Heterojunction transistor according to any one of the preceding claims, in which the thickness of said third GaN layer (15) is between 10 and 100 nm.

6.  Heterojunction transistor according to any one of the preceding claims, in which the dopant concentration of said fourth layer (16) is less than $1 * 10^{16}$ cm$^{-3}$.

7.  Heterojunction transistor according to any one of the preceding claims, in which the thickness of said fourth layer (16) is between 50 and 100 nm.

8.  Heterojunction transistor according to any one of the preceding claims, in which the carbon concentration of said first GaN layer (13) is greater than that of the second and third GaN layers.

9.  Heterojunction transistor (1) according to any one of the preceding claims, in which said semiconductor layer (17) includes AlGaN.

10. Heterojunction transistor (1) according to any one of the preceding claims, comprising another semiconductor layer, made of AlN, the thickness of which is between 0.5 and 2 nm, positioned between the fourth GaN layer and said semiconductor layer formed plumb with the fourth GaN layer.

Fig. 1

Fig. 2

Fig. 3

Fig. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011272708 A

**Littérature non-brevet citée dans la description**

- *Journal of Semiconductors,* 2012, vol. 33 (1

- *Symposium International Power Semiconductor Devices & IC's,* 19 Juin 2014